# EUROPÄISCHE PATENTSCHRIFT

(11) **EP 1 839 334 B1**
(45) Veröffentlichungstag und Bekanntmachung des Hinweises auf die Patenterteilung: **07.05.2008**
(21) Anmeldenummer: 05815672.0
(22) Anmeldetag: 02.12.2005
(51) Int. Cl.: H01L 23/522

(54) **Leiterbahnstruktur zur Minimierung von thermomechanischen Belastungen**
Strip conductor structure for minimizing thermomechanical loads
Structure de pistes conductrices pour minimiser des contraintes thermo-mécaniques

(30) Priorität: 21.01.2005 DE 102005002987
(43) Veröffentlichungstag der Anmeldung: 03.10.2007
(73) Patentinhaber: SIEMENS AKTIENGESELLSCHAFT, 80333 München (DE)
(72) Erfinder: KASPAR, Michael, 85640 Putzbrunn (DE); WEIDNER, Karl, 81245 München (DE); WEINKE, Robert, 81825 München (DE); WULKESCH, Hans, 81739 München (DE)
(86) Internationale Anmeldenummer: PCT/EP2005/056447
(87) Internationale Veröffentlichungsnummer: WO 2006/076984

(56) Entgegenhaltungen:
- WO-A-03/030247
- US-A- 5 162 260
- US-A1- 2004 101 663

## Beschreibung

Die vorliegende Erfindung betrifft eine Vorrichtung nach jeweils einem der Oberbegriffe der Hauptansprüche, und insbesondere Vorrichtung aus einem Halbleiterchip mit einer Oberfläche, auf der mindestens eine elektrische Kontaktfläche angeordnet ist, wobei auf der Oberfläche eine Folie aus elektrisch isolierendem Material, insbesondere durch Vakuum, aufgebracht ist, die eng an der Oberfläche anliegt und an der Oberfläche haftet, wobei die Folie bei der Kontaktfläche ein Fenster aufweist, in welchem diese Kontaktfläche frei von der Folie und flächig mit mindestens einer Schicht aus elektrisch leitendem Material kontaktiert ist.

Bedingt durch das unterschiedliche thermische Ausdehnungsverhalten der beteiligten Materialien entstehen an den Kontaktstellen der Halbleiterbauelemente, und zwar überwiegend in Eckbereichen, thermomechanische Spannungen, die zum Abriss von vollflächig metallisierten Kontaktstellen führen.

Herkömmlicherweise sollen Kontaktunterbrechungen beziehungsweise das Abreißen von Kontaktstellen an Halbleiterbauelementen durch eine Anpassung der thermischen Ausdehnungskoeffizienten der beteiligten Materialien verhindert werden. Diese Lösung ist aufwändig. Materialien mit angepassten Ausdehnungskoeffizienten stehen nicht zur Verfügung.

Die US 2004/101663 A1 offenbart einen gestapelten Durchgangsstift mit verbesserter Zuverlässigkeit in Kupfermetallurgie. Eine integrierte Mehrschichthalbleiterschaltungsstruktur weist eine erste Verbindungsschicht auf, die eine Schicht aus dielektrischem Material über einem Halbleitersubstrat aufweist, wobei die Schicht aus dielektrischem Material eine dichtes Material zur Passivierung von Halbleitervorrichtungen und lokale Verbindungen darunter aufweist. Es wird zudem ein Siliziumsubstrat offenbart, auf dem eine Verbindungsschicht aufgebracht ist, die in einer Passivierungsschicht eingebettet ist. Eine Hochleistungsverbindung ist mittels hoch leitenden Verdrahtungen auf verschiedenen Stufen erzeugt, die voneinander mit Schichten niedriger k Dielektrizitätskonstante isoliert und an erwünschten Punkten durch metallgefüllte Durchgangsstifte verbunden sind.

Die WO 03/030247 A2 offenbart ein Verfahren zum Kontaktieren elektrischer Kontaktflächen auf einer Oberfläche eines Substrats, wobei eine Folie auf Polyimid- oder Epoxidbasis unter Vakuum auf die Oberfläche auflaminiert wird, so dass die Folie die Oberfläche mit den Kontaktflächen eng anliegend bedeckt und auf dieser Oberfläche haftet. Jede zu kontaktierende Kontaktfläche auf der Oberfläche wird durch Öffnen jeweiliger Fenster in der Folie freigelegt. Jede freigelegte Kontaktfläche wird mit einer Schicht aus Metall flächig kontaktiert.

Die WO 02/101830 A2 offenbart elektronische Bauelemente mit einer Vielzahl von mikroelektronischen Federkontakten.

Die US 5 086 337 offenbart eine Verbindungsstruktur sowie eine elektronische Vorrichtung, die diese Struktur verwendet. Es wird eine Kontaktierungsstruktur zur elektrischen Kontaktierung eines elektronischen Bauteils, wie beispielsweise eines Chips auf einem Substrat, das Herstellungsverfahren und eine die Struktur verwendende elektronische Vorrichtung beschrieben.

Die US 2003/0057 515 A1 offenbart ein Herstellungsverfahren für elektronische Schnittstellenstrukturen. Eine derartige Struktur weist ein Substrat auf, wobei ein Bereich mit Elastomeren durch das Substrat getragen wird. Eine strukturierte Metallisierung überdeckt den Elastomerbereich. Die Metallisierung weist zumindest eine fließende kleine Fläche auf, die zumindest teilweise den Elastomerbereich überdeckt.

Es ist Aufgabe der vorliegenden Erfindung Kontaktstellen an Halbleiterbauelementen derart unempfindlich gegenüber thermomechanischen Spannungen zu erzeugen, dass ein Unterbrechen von elektrischen Verbindungen auf einfache Weise wirksam vermieden wird.

Die Aufgabe wird durch eine Vorrichtung gemäß den Hauptansprüchen 1 bis 3 und ein Verfahren gemäß dem Nebenanspruch 19 gelöst. Vorteilhafte Ausgestaltungen finden sich in den Unteransprüchen.

Es werden Leiterbahnen mit Strukturen erzeugt, die derart ausgestaltet sind, dass thermomechanische Spannungen umgelenkt und verteilt werden, so dass ein Abriss von Leiterbahnen und ein Abriss in der Weiterführung der Leiterbahnen verhindert wird. Es wird eine flexible Kontaktierung zur elektrischen Verbindung einer Kontaktfläche mit mindestens einem äußeren Leiter bereitgestellt. Flexibel heißt mechanisch elastisch. Die Flexibilität wird durch die Geometrie der flexiblen Kontaktierung geschaffen.

Die Flexibilität der Kontaktierung wird vorteilhaft insbesondere dadurch verbessert, wenn eine Schicht aus elektrisch leitendem Material als Teil der Kontaktierung die Kontaktfläche lediglich teilweise überdeckt. Es ist besonders vorteilhaft, wenn die Fläche der Schicht aus elektrisch leitendem Material kleiner als die Kontaktfläche ist. Dies verbessert die Bereitstellung einer flexiblen Kontaktierung mittels einer vorteilhaften Formgebung, die die Flexibilität der Kontaktierung erhöht. Auf diese Weise kann die thermomechanische Belastung mittels von der Schicht aus elektrisch leitendem Material ausgehenden, nach außen verlaufenden, der elektrischen Ansteuerung beziehungsweise Auslesung der Halbleiterbauelemente dienenden Leiterbahnen vermindert werden. Diese Leiterbahnen können sich in einen äußeren Anschlussleiter erstrecken. Mehrere Schichten aus elektrisch leitendem Material können nebeneinander auf der Kontaktfläche aufgebracht sein. Diese Schichten können beliebig auf der Kontaktfläche positioniert sein.

Es erstreckt sich ausgehend von der mindestens einen Schicht aus elektrisch leitendem Material mindestens eine radial nach außen verlaufende Leiterbahn in mindestens einen äußeren Anschlussleiter zur Ansteuerung und Auslesung des mindestens einen Halbleiterchips. Radial schließt auch eine spiralförmige Ausdehnung mit ein. Radial meint entlang eines Radius, von innen nach außen erstreckend.

Es erstreckt sich ausgehend von der mindestens einen Schicht aus elektrisch leitendem Material mindestens eine radial nach außen verlaufende Leiterbahn über eine ringförmige äußere Leiterbahn in mindestens einen äußeren Anschlussleiter zur Ansteuerung und Auslesung des mindestens einen Halbleiterchips. Das heißt, nach außen verlaufende Leiterbahnen enden in einem äußeren Leiterbahnring, der die Schicht aus elektrisch leitendem Material umschließt. An dem äußeren Leiterbahnring ist mindestens ein äußerer Anschlussleiter elektrisch angeschlossen. Ringförmig ist ein allgemeiner Begriff für rund und/oder kreisförmig. Ein Ring kann, muss aber nicht, entlang einer Kreislinie verlaufen. Ein Ring kann auch offen sein, d.h. er kann zwei Enden entlang eines Umlaufs aufweisen. Eine ringförmige äußere Leiterbahn kann durch eine innere und eine äußere Kreislinie begrenzt sein.

Gemäß einer weiteren vorteilhaften Ausgestaltung sind mindestens eine ringförmige Leiterbahn und/oder mindestens drei radial nach außen verlaufende Leiterbahnen ausgebildet. Damit kann diese Geometrie beispielsweise mit einem Steuerrad eines Kraftfahrzeugs verglichen werden.

Gemäß einer weiteren vorteilhaften Ausgestaltung weist/weisen die radial verlaufende(n) Leiterbahn(en) mindestens eine eckige Ausbuchtung auf. Diese Zacken können vorteilhaft auf der Isolierschicht bzw. Folie aufgebracht sein und thermomechanische Spannungen aufnehmen.

Gemäß einer weiteren vorteilhaften Ausgestaltung sind mindestens zwei eckige Ausbuchtungen in gleicher Umfangsrichtung orientiert. Auf diese Weise können thermomechanische Spannungen einfach gerichtet abgeleitet werden.

Gemäß einer weiteren vorteilhaften Ausgestaltung erstreckt sich ausgehend von dem Bereich der Schicht aus elektrisch leitendem Material eine spiralförmig radial nach außen verlaufende Leiterbahn in eine ringförmige äußere Leiterbahn. Durch die Bereitstellung einer Spirale kann ebenso wirksam eine flexible Kontaktierung erzeugt werden.

Gemäß einer vorteilhaften Ausgestaltung ist die Schicht aus elektrisch leitendem Material als runder Zentralbereich der Kontaktierung in der Mitte der Kontaktfläche ausgebildet. Der Zentralbereich liegt in der geometrischen Mitte der Kontaktierung. Eine Kontaktierung ist eine flächige Leiterbahnstruktur, die ein geometrisches Gebilde erzeugt. Dieses kann rund, kreisförmig, ringförmig, spiralförmig und auch quadratisch, rechteckig und/oder kantig sein. Entsprechend ist es möglich einen zentralen Bereich des geometrischen Gebildes Kontaktierung zu definieren. Der Zentralbereich kann ebenso rund, kreisförmig, ringförmig, spiralförmig und grundsätzlich auch quadratisch, rechteckig und/oder kantig sein. Andere Formen sind ebenso möglich. Der Zentralbereich ist in der geometrischen Mitte der Kontaktfläche erzeugt, wobei die Schicht aus elektrisch leitendem Material eine der Form der Kontaktfläche entsprechende Form aufweisen kann. Gemäß dieser weiteren Ausgestaltung kann sich ausgehend von dem Zentralbereich mindestens eine radial, nach außen verlaufende Leiterbahn in eine ringförmige äußere Leiterbahn erstrecken.

Gemäß einer weiteren vorteilhaften Ausgestaltung ist der Zentralbereich kreisförmig und weist einen Durchmesser auf, der kleiner als ein Durchmesser der Kontaktfläche ist.

Gemäß einer weiteren vorteilhaften Ausgestaltung erstreckt sich aus der äußeren Leiterbahn der Kontaktierung mindestens ein äußerer Leiter radial. Dabei wird dieser äußere Leiter als Bestandteil der Kontaktierung angesehen. Über diesen äußeren Leiter wird eine Verbindung zu mindestens einem äußeren Anschlussleiter erzeugt, der nicht Teil der Kontaktierung ist.

Gemäß einer weiteren vorteilhaften Ausgestaltung verjüngt sich die Folie beziehungsweise verkleinert sich die Dicke der Folie in Richtung des Fensters. Dies kann stufenartig erfolgen. Auf diese Weise können ebenso thermomechanische Belastungen minimiert werden, da damit der Unterschied von Größenänderungen der Kontaktierung zur Folie ebenso minimiert ist.

Gemäß einer weiteren vorteilhaften Ausgestaltung ist die Folie im Bereich des Fensters kraterförmig und/oder V-förmig ausgebildet, wobei eine Steigung im Bereich größer 20° und kleiner 60° liegt.

Gemäß einer weiteren vorteilhaften Ausgestaltung ist die Kontaktierung mit der Folie und der Kontaktfläche mechanisch verbunden. Damit ist der Verlauf der äußeren Leiterbahn an die Form des Fensters angepasst, so dass ebenso dadurch thermomechanische Belastungen minimiert werden.

Gemäß einer weiteren vorteilhaften Ausgestaltung weist die flexible Kontaktierung Kupfer auf, und/oder die Dicke der flexiblen Kontaktierung ist unter Berücksichtigung der Leistungsaufnahme des Halbleiterchips minimiert. Ist der Halbleiterchip ein Feldeffekttransistor, weist die flexible Kontaktierung zur Ansteuerung eines Gates eine Dicke im Bereich von ca. 10µm bis ca. 100µm auf. Zur elektrischen Kontaktierung einer Source und eines Drains liegt die Dicke der flexiblen Kontaktierung beispielsweise im Bereich von ca. 50µm bis ca. 500µm.

Gemäß einer weiteren vorteilhaften Ausgestaltung ist die Dicke der Folie unter Berücksichtigung deren Isolationseigenschaften minimiert. Das heißt, zur Verringerung thermomechanischer Spannungen wird die Folie so dünn wie möglich derart bereitgestellt, dass diese die Anforderungen an die elektrische Isolation noch erfüllt.

Gemäß einer weiteren vorteilhaften Ausgestaltung wird ein Substrat mit einer Oberfläche verwendet, die mit einem oder mehreren Halbleiterchips bestückt ist, auf deren jedem je eine oder mehrere zu kontaktierende Kontaktflächen vorhanden ist oder sind, und die Folie wird auf diese Oberfläche, insbesondere unter Vakuum, aufgebracht, insbesondere auflaminiert, so dass die Folie diese Oberfläche einschließlich jedes Halbleiterchips und jeder Kontaktfläche eng anliegend bedeckt und auf dieser Oberfläche einschließlich jedes Halbleiterchips haftet.

Gemäß einer weiteren vorteilhaften Ausgestaltung wird ein Substrat mit einer mit einem oder mehreren Leistungshalbleiterchips bestückten Oberfläche verwendet.

Die vorliegende Erfindung wird anhand von Ausführungsbeispielen näher beschrieben. Es zeigen:
- Fig. 1: ein erstes Ausführungsbeispiel einer erfindungsgemäßen Leiterbahnstruktur;
- Fig. 2: einen Querschnitt des ersten Ausführungsbeispiels;
- Fig. 3: ein zweites Ausführungsbeispiel einer Erfindungsgemäßen Leiterbahnstruktur;
- Fig. 4: einen Querschnitt des zweiten Ausführungsbeispiels.

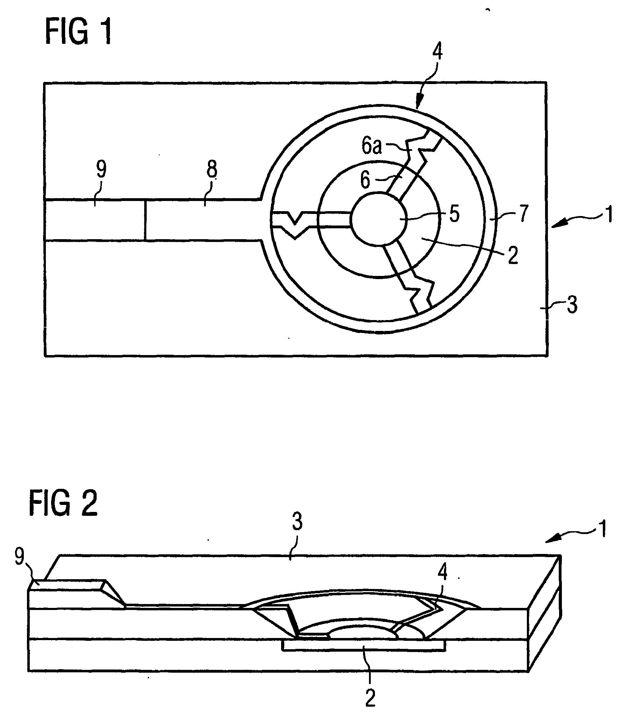

Fig. 1 zeigt ein erstes Ausführungsbeispiel einer erfindungsgemäßen Leiterbahnstruktur. Es ist eine flexible Kontaktierung 4 dargestellt, wobei eine Schicht aus elektrisch leitendem Material Teil der flexiblen Kontaktierung 4 zur elektrischen Verbindung der Kontaktfläche 2 eines Chips 1 mit einem äußeren Leiter 8 ist. Die Schicht aus elektrisch leitendem Material ist als runder und kreisförmiger Zentralbereich 5 der Kontaktierung 4 ausgebildet. Die Fläche der Schicht aus elektrisch leitendem Material ist kleiner als die Kontaktfläche 2. Ausgehend von dem Zentralbereich 5 erstrecken sich drei radial nach außen verlaufende Leiterbahnen 6 in eine ringförmige äußere Leiterbahn 7. Die radial verlaufenden Leiterbahnen 6 weisen jeweils eine eckige Ausbuchtung 6a auf. Eine eckige Ausbuchtung 6a kann auch als Zacken 6a angesehen werden. Die eckigen Ausbuchtungen 6a sind in gleicher Umfangsrichtung orientiert. Die äußere Leiterbahn 7 umrahmt das Fenster.

Fig. 2 zeigt einen Querschnitt des ersten Ausführungsbeispiels einer flexiblen Kontaktierung 4. Auf dem Chip 1 ist eine Isolierschicht 3 beziehungsweise eine Isolierfolie 3 aufgebracht. Auf einem Chip 1 ist in einem kraterförmigen Fenster der Isolierschicht 3 eine Kontaktstelle 2 aufgebracht, die mittels der Kontaktierung 4 mit einem Anschlussleiter 9 elektrisch verbunden. Die Kontaktierung 4 weist hier eine Form auf, die mit der eines Steuerrades in einem Kraftfahrzeug vergleichbar ist.

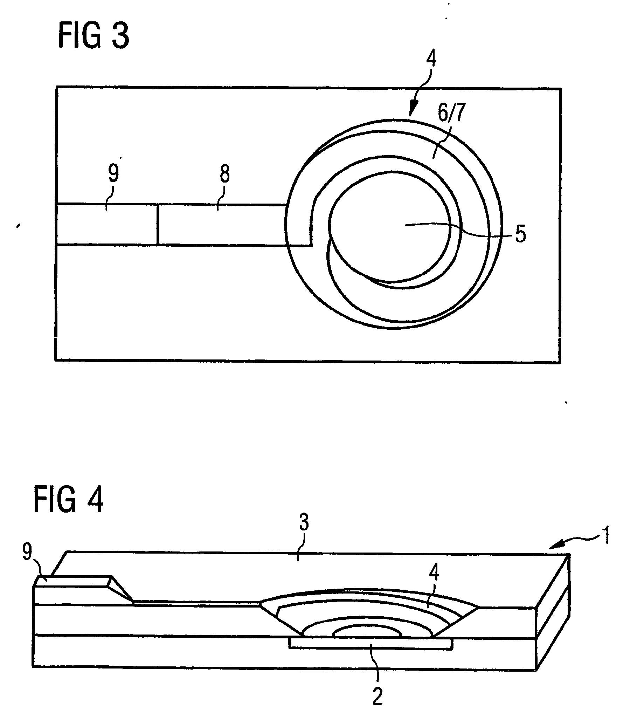

Fig. 3 zeigt ein zweites Ausführungsbeispiel einer Kontaktierung 4. Ausgehend von einem Zentralbereich 5 erstreckt sich eine spiralförmig radial nach außen verlaufende Leiterbahn 6 in eine ringförmige äußere Leiterbahn 7. Die Kontaktierung 4 kann als Ganzes als eine Leiterbahnspirale angesehen werden. Die spiralförmige Leiterbahn weist außerhalb des Zentralbereichs 5 in etwa eine Breite auf, die der Breite des äußeren Leiters 8 entspricht. Bezugszeichen 9 bezeichnet einen äußeren Anschlussleiter 9 zur Ansteuerung und Auslesung des mindestens einen Halbleiterchips 1.

Fig. 4 zeigt einen Querschnitt des zweiten Ausführungsbeispiels. Auf dem Chip 1 ist eine Isolierschicht 3 beziehungsweise eine Isolierfolie 3 aufgebracht. Auf einem Chip 1 ist in einem kraterförmigen Fenster der Isolierschicht 3 eine Kontaktstelle 2 aufgebracht, die mittels der Kontaktierung 4 mit einem Anschlussleiter 9 elektrisch verbunden ist. Die Kontaktierung 4 weist hier die Form einer Spirale auf.

In Fig. 1 und 3 erstreckt sich aus der äußeren ringförmigen Leiterbahn 7 der Kontaktierung 4 ein äußerer Leiter 8, und zwar radial zum Zentralbereich 5. Dieser äußere Leiter 8 ist eine Verbindung zu einem äußeren Anschlussleiter 9, mittels dem der Chip 1 angesteuert und/oder ausgelesen wird. Der Zentralbereich 5 ist im Wesentlichen kreisförmig und weist einen Durchmesser auf, der kleiner als ein Durchmesser der Kontaktfläche 2 ist. Die Isolierschicht 3 beziehungsweise Folie 3 ist im Bereich des Fensters kraterförmig ausgebildet. Auf diese Weise kann die Leiterbahnführung nach außen vereinfacht werden. Die Kontaktierung 4 ist mit der Folie 3 und der Kontaktfläche 2 mechanisch verbunden. Gemäß einer weiteren vorteilhaften Ausgestaltung weisen die ringförmigen, die radialen und/oder die spiralförmigen Leiterbahnen eine Breite auf, die der Breite eines äußeren Leiters 8 entsprechen.

## Patentansprüche

1. Vorrichtung aus einem Halbleiterchip (1) mit einer Oberfläche, auf der mindestens eine elektrische Kontaktfläche (2) angeordnet ist, wobei auf der Oberfläche eine Folie (3) aus elektrisch isolierendem Material aufgebracht ist, wobei die Folie (3) bei der Kontaktfläche (2) ein Fenster aufweist, in welchem diese Kontaktfläche (2) frei von der Folie (3) und flächig mit mindestens einer Schicht aus elektrisch leitendem Material kontaktiert ist, wobei die Schicht aus elektrisch leitendem Material Teil einer aufgrund deren Geometrie mechanisch elastischen Kontaktierung (4) zur elektrischen Verbindung der Kontaktfläche (2) mit mindestens einem äußeren Anschlussleiter (9) ist, wobei ausgehend von der Schicht aus elektrisch leitendem Material sich mindestens eine radial nach außen verlaufende Leiterbahn (6) über eine äußere Leiterbahn (7) in den äußeren Anschlussleiter (9) erstreckt,
**dadurch gekennzeichnet, dass**
die äußere Leiterbahn (7) das Fenster umrahmt und dass der äußere Anschlussleiter (9) auf der Folie (3) angeordnet ist.

2. Vorrichtung aus einem Substrat mit einer Oberfläche, auf der mindestens eine elektrische Kontaktfläche (2) angeordnet ist, wobei auf der Oberfläche eine Folie (3) aus elektrisch isolierendem Material aufgebracht ist, wobei die Folie (3) bei der Kontaktfläche (2) ein Fenster aufweist, in welchem diese Kontaktfläche (2) frei von der Folie (3) und flächig mit mindestens einer Schicht aus elektrisch leitendem Material kontaktiert ist, wobei die Schicht aus elektrisch leitendem Material Teil einer aufgrund deren Geometrie mechanisch elastischen Kontaktierung (4) zur elektrischen Verbindung der Kontaktfläche (2) mit mindestens einem äußeren Anschlussleiter (9) ist, wobei ausgehend von der Schicht aus elektrisch leitendem Material sich mindestens eine radial nach außen verlaufende Leiterbahn (6) über eine äußere Leiterbahn (7) in den äußeren Anschlussleiter (9) erstreckt,
**dadurch gekennzeichnet, dass**
die äußere Leiterbahn (7) das Fenster umrahmt und dass der äußere Anschlussleiter (9) auf der Folie (3) angeordnet ist.

3. Vorrichtung nach Anspruch 2, mit mindestens einer zu der Kontaktfläche (2) auf dem Substrat alternativen oder zusätzlichen Kontaktfläche (2) auf mindestens einem Halbleiterchip (1) auf der Oberfläche des Substrats, wobei auf der Oberfläche des Halbleiterchips (1) eine Folie (3) aus elektrisch isolierendem Material aufgebracht ist, wobei die Folie (3) bei der Kontaktfläche (2) auf dem Halbleiterchip (1) ein Fenster aufweist, in welchem diese Kontaktfläche (2) frei von der Folie (3) flächig mit mindestens einer Schicht aus elektrisch leitendem Material kontaktiert ist, wobei die Schicht aus elektrisch leitendem Material Teil einer aufgrund deren Geometrie mechanisch elastischen Kontaktierung (4) zur elektrischen Verbindung der Kontaktfläche (2) mit mindestens einem äußeren Anschlussleiter (9) ist, wobei ausgehend von der Schicht aus elektrisch leitendem Material sich mindestens eine radial nach außen verlaufende Leiterbahn (6) über eine äußere Leiterbahn (7) in den äußeren Anschlussleiter (9) erstreckt, **dadurch gekennzeichnet, dass**
die äußere Leiterbahn (7) das Fenster umrahmt und dass der äußere Anschlussleiter (9) auf der Folie (3) angeordnet ist.

4. Vorrichtung nach einem der vorangehenden Ansprüche,
**dadurch gekennzeichnet, dass**
die Fläche der Schicht aus elektrisch leitendem Material kleiner als die Kontaktfläche (2) ist.

5. Vorrichtung nach einem oder mehreren der Ansprüche 1 bis 4,
**dadurch gekennzeichnet, dass**
mindestens drei radial verlaufende Leiterbahnen (6) und mindestens eine ringförmige äußere Leiterbahn (7) ausgebildet sind.

6. Vorrichtung nach einem oder mehreren der Ansprüche 1 bis 5,
**dadurch gekennzeichnet, dass**
die radial verlaufende(n) Leiterbahn(en) (6) mindestens eine eckige Ausbuchtung aufweist/en.

7. Vorrichtung nach Anspruch 6,
**dadurch gekennzeichnet, dass**
mindestens zwei eckige Ausbuchtungen in gleicher Umfangsrichtung orientiert sind.

8. Vorrichtung nach einem oder mehreren der vorangehenden Ansprüche 1 bis 7,
**dadurch gekennzeichnet, dass**
ausgehend von der Schicht aus elektrisch leitendem Material sich mindestens eine spiralförmig radial nach außen verlaufende Leiterbahn (6) in eine ringförmige äußere Leiterbahn (7) erstreckt.

9. Vorrichtung nach einem oder mehreren der Ansprüche 1 bis 8,
**dadurch gekennzeichnet, dass**
die Schicht aus elektrisch leitendem Material als Zentralbereich (5) in der Mitte der Kontaktfläche (2) ausgebildet ist.

10. Vorrichtung nach Anspruch 9,
**dadurch gekennzeichnet, dass**
der Zentralbereich (5) kreisförmig ist und einen Durchmesser aufweist, der kleiner als ein Durchmesser der Kontaktfläche (2) ist.

11. Vorrichtung nach einem oder mehreren der vorangehenden Ansprüche 1 bis 10,
**dadurch gekennzeichnet, dass**
sich aus der äußeren ringförmigen Leiterbahn (7) der Kontaktierung (4) mindestens ein äußerer Leiter (8) radial erstreckt.

12. Vorrichtung nach einem oder mehreren der vorangehenden Ansprüche 1 bis 11,
**dadurch gekennzeichnet, dass**
die Folie (3) sich in Richtung zu der Kontaktfläche (2) stufenartig, verjüngt.

13. Vorrichtung nach einem oder mehreren der vorangehenden Ansprüche 1 bis 12,
**dadurch gekennzeichnet, dass**
die Folie (3) im Bereich des Fensters im Querschnitt V-förmig ausgebildet ist, und eine Steigung im Bereich größer 20° und kleiner 60° aufweist.

14. Vorrichtung nach einem oder mehreren der vorangehenden Ansprüche 1 bis 13,
**dadurch gekennzeichnet, dass**
die Kontaktierung (4) mit der Folie (3) und der Kontaktfläche (2) mechanisch verbunden ist.

15. Vorrichtung nach einem oder mehreren der vorangehenden Ansprüche 1 bis 14,
**dadurch gekennzeichnet, dass**
die flexible Kontaktierung (4) Kupfer, aufweist, und/oder die Dicke der flexiblen Kontaktierung (4) unter Berücksichtigung der Leistungsaufnahme des Halbleiterchips (1) minimiert ist.

16. Vorrichtung nach einem oder mehreren der vorangehenden Ansprüche 1 bis 15,
**dadurch gekennzeichnet, dass**
die Dicke der Folie (3) unter Berücksichtigung deren Isolationseigenschaften minimiert ist.

17. Verfahren zum Kontaktieren einer Vorrichtung nach einem oder mehreren der vorangehenden Ansprüche 1 bis 16 mit einer oder mehreren elektrischen Kontaktflächen (2), mit den Schritten:
- Aufbringen einer Folie (3) aus elektrisch isolierendem Kunststoffmaterial auf die Oberfläche des Substrats,
- Freilegen jeder zu kontaktierenden Kontaktfläche (2) auf der Oberfläche durch Öffnen jeweiliger Fenster in der Folie (3), und
- flächiges Kontaktieren jeder freigelegten Kontaktfläche (2) mit mindestens einer Schicht aus elektrisch leitendem Material.

18. Verfahren nach Anspruch 17, wobei ein Substrat mit einer Oberfläche verwendet wird, die mit einem oder mehreren Halbleiterchips (1) bestückt ist, auf deren jedem je eine oder mehrere zu kontaktierende Kontaktflächen (2) vorhanden ist oder sind, und wobei die Folie (3) auf diese Oberfläche, insbesondere unter Vakuum, aufgebracht wird, so dass die Folie (3) diese Oberfläche einschließlich jedes Halbleiterchips (1) und jeder Kontaktfläche (2) eng anliegend bedeckt und auf dieser Oberfläche einschließlich jedes Halbleiterchips (1) haftet.

19. Verfahren nach Anspruch 18, wobei ein Substrat mit einer mit einem oder mehreren Leistungshalbleiterchips (1) bestückten Oberfläche verwendet wird.

## Claims

1. Device consisting of a semiconductor chip device (1) having a surface on which at least one electrical contact surface (2) is arranged, whereby a foil (3) made from electrically insulating material is provided on the surface, whereby the foil (3) has a window at the contact surface (2) in which this contact surface (2) is free of the foil (3) and planar contact is established with at least one layer made from electrically conducting material, whereby the layer made from electrically conducting material is part of a contacting facility (4), which on account of its geometry is mechanically flexible, for establishing the electrical connection between the contact surface (2) and at least one outer connecting conductor (9), whereby originating from the layer made from electrically conducting material, at least one strip conductor (6) running radially towards the outside extends into the outer connecting conductor (9) by way of an outer strip conductor (7),
**characterised in that**
the outer strip conductor (7) frames the window and that the outer connecting conductor (9) is arranged on the foil (3).

2. Device made from a substrate with a surface on which at least one electrical contact surface (2) is arranged, whereby a foil (3) made from electrically insulating material is provided on the surface, whereby the foil (3) has a window at the contact surface (2) in which this contact surface (2) is free of the foil (3) and planar contact is established with at least one layer made from electrically conducting material, whereby the layer made from electrically conducting material is part of a contacting facility (4), which on account of its geometry is mechanically flexible, for establishing the electrical connection between the contact surface (2) and at least one outer connecting conductor (9), whereby originating from the layer made from electrically conducting material, at least one strip conductor (6) running radially towards the outside extends into the outer connecting conductor (9) by way of an outer strip conductor (7),
**characterised in that**
the outer strip conductor (7) frames the window and that the outer connecting conductor (9) is arranged on the foil (3).

3. Device according to claim 2, with at least one contact surface (2), alternative to or in addition to the contact surface (2) on the substrate, on at least one semiconductor chip (1) on the surface of the substrate, whereby a foil (3) made from electrically insulating material is provided on the surface, whereby the foil (3) has a window at the contact surface (2) on the semiconductor chip (1) in which this contact surface (2) is free of the foil (3) and planar contact is established with at least one layer made from electrically conducting material, whereby the layer made from electrically conducting material is part of a contacting facility (4), which on account of its geometry is mechanically flexible, for establishing the electrical connection between the contact surface (2) and at least one outer connecting conductor (9), whereby originating from the layer made from electrically conducting material, at least one strip conductor (6) running radially towards the outside extends into the outer connecting conductor (9) by way of an outer strip conductor (7),
**characterised in that**
the outer strip conductor (7) frames the window and that the outer connecting conductor (9) is arranged on the foil (3).

4. Device according to one of the preceding claims,
**characterised in that**
the area of the layer made from electrically conducting material is smaller than the contact surface (2).

5. Device according to one or more of claims 1 to 4,
**characterised in that**
at least three strip conductors (6) running radially and at least one ring-shaped outer strip conductor (7) are implemented.

6. Device according to one or more of claims 1 to 5,
**characterised in that**
the strip conductor(s) (6) running radially has/have at least one angular bulge.

7. Device according to claim 6,
**characterised in that**
at least two angular bulges are oriented in the same circumferential direction.

8. Device according to one or more of the preceding claims 1 to 7,
**characterised in that**
originating from the layer made from electrically conducting material, at least one strip conductor (6) running radially in a spiral towards the outside extends into a ring-shaped outer strip conductor (7).

9. Device according to one or more of claims 1 to 8,
**characterised in that**
the layer made from electrically conducting material is implemented as a central area (5) in the centre of the contact surface (2).

10. Device according to claim 9,
**characterised in that**
the central area (5) is circular and has a diameter which is smaller than a diameter of the contact surface (2).

11. Device according to one or more of the preceding claims 1 to 10,
**characterised in that**
at least one outer conductor (8) extends radially out of the outer ring-shaped strip conductor (7) of the contacting facility (4).

12. Device according to one or more of the preceding claims 1 to 11,
**characterised in that**
the foil (3) narrows stepwise in the direction of the contact surface (2).

13. Device according to one or more of the preceding claims 1 to 12,
**characterised in that**
the foil (3) in the area of the window is V-shaped in cross-section, and has a gradient in the range greater than 20° and less than 60°.

14. Device according to one or more of the preceding claims 1 to 13,
**characterised in that**
the contacting facility (4) is connected mechanically with the foil (3) and the contact surface (2).

15. Device according to one or more of the preceding claims 1 to 14,
**characterised in that**
the flexible contacting facility (4) features copper, and/or the thickness of the flexible contacting facility (4) is minimised having regard to the power consumption of the semiconductor chip (1).

16. Device according to one or more of the preceding claims 1 to 15,
**characterised in that**
the thickness of the foil (3) is minimised having regard to its insulating properties.

17. Method for making contact between a device according to one or more of the preceding claims 1 to 16 with one or more electrical contact surfaces (2), comprising the steps:
- applying a foil (3) made from electrically insulating plastic material onto the surface of the substrate,
- exposing each contact surface (2) to be contacted on the surface by opening respective windows in the foil (3), and
- establishing planar contact between each exposed contact surface (2) and at least one layer made from electrically conducting material.

18. Method according to claim 17, whereby a substrate with a surface is used which is equipped with one or more semiconductor chips (1), on each of which one or more contact surfaces (2) to be contacted is or are present in each case, and whereby the foil (3) is applied, particularly under vacuum, to this surface, such that the foil (3) very tightly covers this surface including each semiconductor chip (1) and each contact surface (2) and adheres on this surface including each semiconductor chip (1).

19. Method according to claim 18, whereby a substrate with a surface equipped with one or more power semiconductor chips (1) is used.

## Revendications

1. Dispositif de puce à semi-conducteur (1) qui présente une surface sur laquelle est disposée au moins une surface de contact électrique (2), un film (3) de matériau électriquement isolant étant déposé sur la surface, ledit film (3) présentant au niveau de la surface de contact (2) une fenêtre dans laquelle cette surface de contact (2) est dépourvue de film (3) et est en contact superficiel avec au moins une couche de matériau électriquement conducteur, ladite couche de matériau électriquement conducteur étant une partie d'un contact de connexion (4) mécano-élastique du fait de sa géométrie destiné à la connexion électrique de la surface de contact (2) avec au moins un conducteur de connexion extérieur (9), et au moins une piste conductrice (6) se déployant radialement vers l'extérieur s'étendant depuis ladite couche de matériau électriquement conducteur, à travers une piste conductrice extérieure (7), dans ledit conducteur de connexion extérieur (9), **caractérisé en ce que**
la piste conductrice extérieure (7) encadre la fenêtre et **en ce que** le conducteur de connexion extérieur (9) est disposé sur le film (3).

2. Dispositif de substrat qui présente une surface sur laquelle est disposée au moins une surface de contact électrique (2), un film (3) de matériau électriquement isolant étant déposé sur la surface, ledit film (3) présentant au niveau de la surface de contact (2) une fenêtre dans laquelle cette surface de contact (2) est dépourvue de film (3) et est en contact superficiel avec au moins une couche de matériau électriquement conducteur, ladite couche de matériau électriquement conducteur étant une partie d'un contact de connexion (4) mécano-élastique du fait de sa géométrie destiné à la connexion électrique de la surface de contact (2) avec au moins un conducteur de connexion extérieur (9), et au moins une piste conductrice (6) se déployant radialement vers l'extérieur s'étendant depuis ladite couche de matériau électriquement conducteur, à travers une piste conductrice extérieure (7), dans ledit conducteur de connexion extérieur (9), **caractérisé en ce que**
la piste conductrice extérieure (7) encadre la fenêtre et **en ce que** le conducteur de connexion extérieur (9) est disposé sur le film (3).

3. Dispositif selon la revendication 2, présentant au moins une surface de contact (2) alternative ou supplémentaire à la surface de contact (2) sur le substrat, sur au moins une puce à semi-conducteur (1) sur la surface du substrat, un film (3) de matériau électriquement isolant étant déposé sur la surface de la puce à semi-conducteur (1), ledit film (3) présentant au niveau de la surface de contact (2) sur la puce à semi-conducteur (1) une fenêtre dans laquelle cette surface de contact (2) est dépourvue de film (3) et est en contact superficiel avec au moins une couche de matériau électriquement conducteur, ladite couche de matériau électriquement conducteur étant une partie d'un contact de connexion (4) mécano-élastique du fait de sa géométrie destiné à la connexion électrique de la surface de contact (2) avec au moins un conducteur de connexion extérieur (9), et au moins une piste conductrice (6) se déployant radialement vers l'extérieur s'étendant depuis ladite couche de matériau électriquement conducteur, à travers une piste conductrice extérieure (7), dans ledit conducteur de connexion extérieur (9), **caractérisé en ce que**
la piste conductrice extérieure (7) encadre la fenêtre et **en ce que** le conducteur de connexion extérieur (9) est disposé sur le film (3).

4. Dispositif selon l'une des revendications précédentes,
**caractérisé en ce que**
la superficie de la couche de matériau électriquement conducteur est inférieure à celle de la surface de contact (2).

5. Dispositif selon l'une ou plusieurs des revendications 1 à 4,
**caractérisé en ce que**
au moins trois pistes conductrices (6) se déployant radialement et au moins une piste conductrice extérieure (7) de forme annulaire sont réalisées.

6. Dispositif selon l'une ou plusieurs des revendications 1 à 5,
**caractérisé en ce que**
la ou les piste(s) conductrice(s) (6) se déployant radialement présente(nt) au moins une aspérité anguleuse.

7. Dispositif selon la revendication 6,
**caractérisé en ce que**
au moins deux aspérités anguleuses sont orientées dans un même sens circonférentiel.

8. Dispositif selon l'une ou plusieurs des revendications précédentes 1 à 7,
**caractérisé en ce que**
au moins une piste conductrice (6) se déployant en spirale radialement vers l'extérieur s'étend depuis ladite couche de matériau électriquement conducteur dans une piste conductrice extérieure (7) de forme annulaire.

9. Dispositif selon l'une ou plusieurs des revendications 1 à 8,
**caractérisé en ce que**
la couche de matériau électriquement conducteur est réalisée comme zone centrale (5) au centre de la surface de contact (2).

10. Dispositif selon la revendication 9,
**caractérisé en ce que**
la zone centrale (5) est de forme circulaire et présente un diamètre, lequel est inférieur à un diamètre de la surface de contact (2).

11. Dispositif selon l'une ou plusieurs des revendications précédentes 1 à 10,
**caractérisé en ce que**
au moins un conducteur extérieur (8) s'étend radialement depuis la piste conductrice extérieure (7) de forme annulaire du contact de connexion (4).

12. Dispositif selon l'une ou plusieurs des revendications précédentes 1 à 11,
**caractérisé en ce que**
le film (3) s'amincit graduellement en direction de la surface de contact (2).

13. Dispositif selon l'une ou plusieurs des revendications précédentes 1 à 12,
**caractérisé en ce que**, dans la zone de fenêtre,
le film (3) est réalisé en section transversale en forme de V et présente une pente située dans la fourchette supérieure à 20° et inférieure à 60°.

14. Dispositif selon l'une ou plusieurs des revendications précédentes 1 à 13,
**caractérisé en ce que**
le contact de connexion (4) est relié mécaniquement au film (3) et à la surface de contact (2).

15. Dispositif selon l'une ou plusieurs des revendications précédentes 1 à 14,
**caractérisé en ce que**
le contact de connexion flexible (4) comporte du cuivre et/ou l'épaisseur du contact de connexion flexible (4) est minimisée compte tenu de la puissance absorbée de la puce à semi-conducteur (1).

16. Dispositif selon l'une ou plusieurs des revendications précédentes 1 à 15,
**caractérisé en ce que**
l'épaisseur du film (3) est minimisée compte tenu des propriétés isolantes de celui-ci.

17. Procédé de mise en contact d'un dispositif selon l'une ou plusieurs des revendications précédentes 1 à 16 présentant une ou plusieurs surfaces de contact électrique (2), comprenant les étapes :
- dépôt d'un film (3) de matériau plastique électriquement isolant sur la surface du substrat,
- dégagement de chaque surface de contact (2) devant être mise en contact sur la surface, en ouvrant des fenêtres respectives dans le film (3), et
- mise en contact superficiel de chaque surface de contact (2) dégagée avec au moins une couche de matériau électriquement conducteur.

18. Procédé selon la revendication 17, dans lequel on utilise un substrat présentant une surface équipée d'une ou de plusieurs puces à semi-conducteur (1) dont chacune porte une ou plusieurs surfaces de contact (2) devant être mise en contact, et dans lequel on dépose le film (3) sur cette surface, en particulier sous vide, de sorte que le film (3) recouvre cette surface en contact étroit, y compris chaque puce à semi-conducteur (1) et chaque surface de contact (2), et adhère à cette surface, y compris chaque puce à semi-conducteur (1).

19. Procédé selon la revendication 18, dans lequel on utilise un substrat présentant une surface équipée d'une ou de plusieurs puces à semi-conducteur de puissance (1).
